(19) Europäisches Patentamt
European Patent Office
Office européen des brevets

(11) **EP 2 533 128 B1**

(12) **EUROPEAN PATENT SPECIFICATION**

(45) Date of publication and mention
of the grant of the patent:
**08.01.2014 Bulletin 2014/02**

(51) Int Cl.:
*G05F 3/08* (2006.01)   *H03G 1/00* (2006.01)
*H05B 33/08* (2006.01)

(21) Application number: **11169336.2**

(22) Date of filing: **09.06.2011**

(54) **Regulated current source and method for providing a regulated output current**

Gesteuerte Stromquelle und Verfahren zum Beschaffen einer gesteuerten Stromquelle

Source de courant régulée et procédé pour la fourniture d'un courant à sortie régulée

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**12.12.2012 Bulletin 2012/50**

(73) Proprietor: **ams AG
8141 Unterpremstätten (AT)**

(72) Inventor: **Singnurkar, Pramod
8052 Graz (AT)**

(74) Representative: **Epping - Hermann - Fischer
Patentanwaltsgesellschaft mbH
Ridlerstrasse 55
80339 München (DE)**

(56) References cited:
EP-A1- 2 197 244          WO-A1-2006/137034
WO-A2-01/35529          US-A- 5 218 320
US-A1- 2002 063 592          US-A1- 2002 176 188
US-A1- 2007 278 994          US-A1- 2007 290 746

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention is related to a regulated current source and to a method for providing a regulated output current.

Current sources are commonly used for several different applications, for instance to drive lightening diodes of a backlight panel in a TV.

Document EP 2 197 244 A1 describes a current source with an output transistor controlled by a first control loop. The first loop comprises a sensing transistor being operated in saturation. The current source of EP 2 197 244 A1 further comprises a second loop having a second sensing transistor being operated in its linear mode of operation.

Document US 2007/0290746 A1 describes a control for an adjustable gain amplifier having a main adjustable gain element and a replica adjustable gain element, which is preferably arranged on the same semiconductor die as the main gain element. A control loop is provided which controls the gain of the replica adjustable gain element by comparing its output voltage to a reference voltage. The resulting control voltage used for controlling the replica adjustable gain element is provided to the main adjustable gain element.

The number of such current sources to control lightning diodes has constantly increased for such applications. As a consequence, the need to reduce the overall size, costs and complexity of those current sources has increased as well.

This and other needs are taken into account by the current independent claims. Further embodiments and different aspects of the invention are a subject matter of the dependent claims.

An aspect of the invention is related to a regulated current source comprising controllable output means coupled to a supply terminal and to an output terminal to provide a respective output current. A first regulation loop comprises first comparing means to provide a control signal to the controllable output means in response to a feedback signal and a reference signal. As such, the first regulation loop may regulate the output current to a specific value in response to the reference signal. Further, the regulated current source may comprise a first switch between the controllable output means and output of the first comparing means. An offset cancellation loop having second comparing means is coupled with its input to the output of the first comparing means to provide an offset cancellation signal to the first comparing means. A unity gain buffer is coupled to a node between the first switch and the controllable output means and is selectively switchable arranged in parallel to the first switch. To this extent, the present invention proposes two loops to control an output current, whereby the first regulation loop provides a regulation for the output current while the second loop acts to cancel any offset generated in the first regulation loop. The unity gain buffer offers offset cancellation prior to signal application and operation of the regulation loop. As a result, there is no limitation of bandwidth compared to known implementations.

In an aspect, the first switch of a regulated current source is adapted to be closed during a regulation cycle of the first regulation loop. During the regulation cycle, the first regulation loop provides a regulated output current. The offset cancellation loop is adapted to provide the offset cancellation signal during a refresh cycle of the first regulation loop. Finally, the unity gain buffer is adapted to be operated between the refresh cycle and the regulation cycle. Due to the operation of the gain buffer between the refresh cycle and the regulation cycle, the output of the first comparing means and the control input are at the same potential at the start of the regulation cycle.

In accordance with the present invention, the regulated current source is operated in three different consecutive cycles. During a regulation cycle, the first regulation loop is active and provides a respective control signal such as a controllable output means. To reduce an offset in the first regulation loop, a refresh cycle follows the regulation cycle consecutively. During the refresh cycle, the offset cancellation loop is active to evaluate an offset of the first regulation loop. In response to an evaluated offset, the offset cancellation loop provides a respective cancellation signal to the first regulation loop. Said cancellation signal may be used in the regulation cycle. After the refresh cycle and before the following regulation cycle, the unity gain buffer is operated.

The gain buffer equalizes the signal at the node between the first switch and the controllable output means to a signal between the output of the first regulation loop and the first switch. As a result, any glitches during transition from the refresh cycle to the regulation cycle are significantly reduced.

In an aspect of the present invention, the first comparing means comprise a differential operational amplifier, wherein at least one output is coupled to the first switch. The second comparing means may also comprise a differential amplifier coupled with its input via respective switches to the output of the first comparing means and with its output to a supply of the first comparing means.

In accordance with the present invention, the second comparing means provide a cancellation signal, that cancellation signal being the supply signal for the first comparing means.

In a further aspect, the second comparing means may comprise at least one capacitor coupled between one of the inputs and the respective switch. The capacitor provides a signal storage to the offset cancellation loop.

To further reduce any glitches, particularly with respect to a ground potential, a capacitor may be coupled to the supply terminal and the node.

In another aspect, the unity gain buffer may be adapted to mirror a signal at the node to the output of the first regulation loop between the refresh cycle and the regulation cycle.

Further aspects and principles of the present invention are now illustrated in greater detail with respect to the accompanying drawings, in which:

FIG. 1 illustrates a first embodiment of the present invention;

FIG. 2 shows a time signal diagram for several control signals applied to the embodiment of FIG. 1 during operation;

FIG. 3 shows an embodiment of a unity gain buffer to be implemented in the embodiment of FIG. 1 in accordance with the present invention;

FIG. 4 shows an embodiment of an operational amplifier according to the present invention;

FIG. 5 illustrates an embodiment of an operational amplifier in the offset cancellation loop in accordance with the present invention;

FIG. 6 shows a known regulated current source.

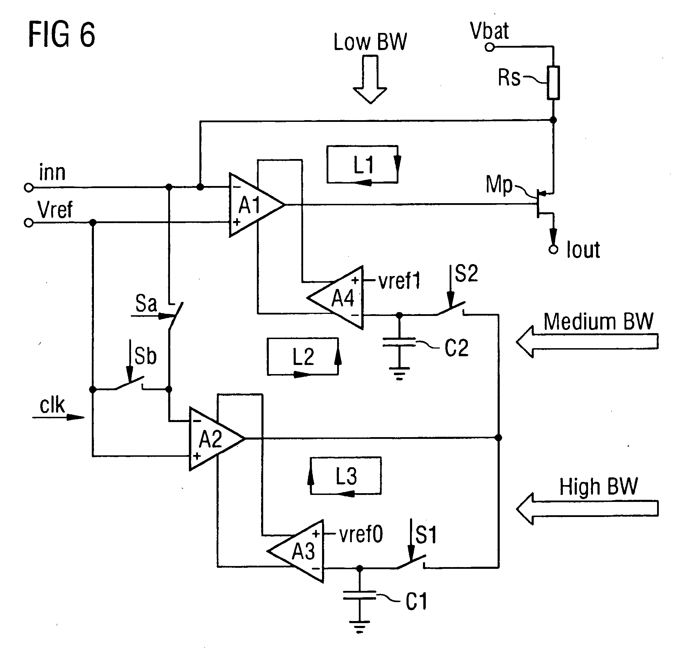

FIG. 6 shows a regulated current source comprising several regulation loops with different bandwidths to provide a respective output current Iout. The known regulated current source includes a first regulation loop L1 having a low bandwidth, a first offset cancellation loop L2 with a medium bandwidth, and a second offset cancellation loop L3 with a high bandwidth. The second offset cancellation loop L3 is used to cancel any offset of an operational amplifier A2 in the first offset cancellation loop.

The first regulation loop L1 comprises a comparator A1 with its output coupled to a current output transistor Mp. The current output transistor is connected between the supply terminal Vbat and an output terminal for providing the output current Iout. A feedback is coupled between power transistor Mp and the inverting input for operational amplifier A1, thereby implementing the first regulation loop.

The operational amplifier A1 compares the feedback signal with a reference signal Vref applied to its non-inverting input and provides a respective control signal to the gate of output transistor Mp. To cancel any offset of the operational amplifier A1, three other operational amplifiers A2, A3 and A4 are used. The operational amplifier A2 forming a portion of the first cancellation loop L2 also requires its own offset cancellation loop implemented by the second offset cancellation loop L3 and the operational amplifier A3.

For offset cancellation as well as for regulation, several switches are arranged in the regulated current source. The current source itself is operated by a clock signal.

In a first switching phase of the clock, the switches Sa between the inverting and non-inverting input of operation amplifier A2 and S1 are closed. Capacitor C1 thereby stores voltage equal two a reference signal Vref0, as operational amplifier A3 of the second offset cancellation loop L3 provides a respective supply signal to operational amplifier A2.

In a second phase of the clock signal, switches SB and S1 are open, while switches S2 and Sa are closed. During this phase, the output signal of operational amplifier A2 now with a significantly reduced offset due to the offset cancellation loop L3 provides a control signal to the inverting input of operational amplifier A4 and capacitor C2. At the same time, operational amplifier A2 receives the reference signal Vref at its non-inverting input and the feedback signal from the main regulation loop L1 at its inverting input signal.

In steady state, capacitor C2 stores a voltage equal to reference voltage Vref1, as operational amplifier A4 provides the offset cancellation signal for operational amplifier A1 in the main loop. If regulation loop L1 is active, operational amplifier A1 will have a balanced offset signal over a number of clock cycles.

To provide the respective stability of all regulation and offset cancellation loops, offset cancellation loop L3 requires a high bandwidth than offset cancellation loop L2. At the same time, the main regulation loop L1 requires a lower bandwidth compared to the first cancellation loop. This poses a bandwidth limit.

Further to this limitation, an offset cancellation is only achieved if the main regulation loop L1 is stable. During transience, no offset cancellation may exist.

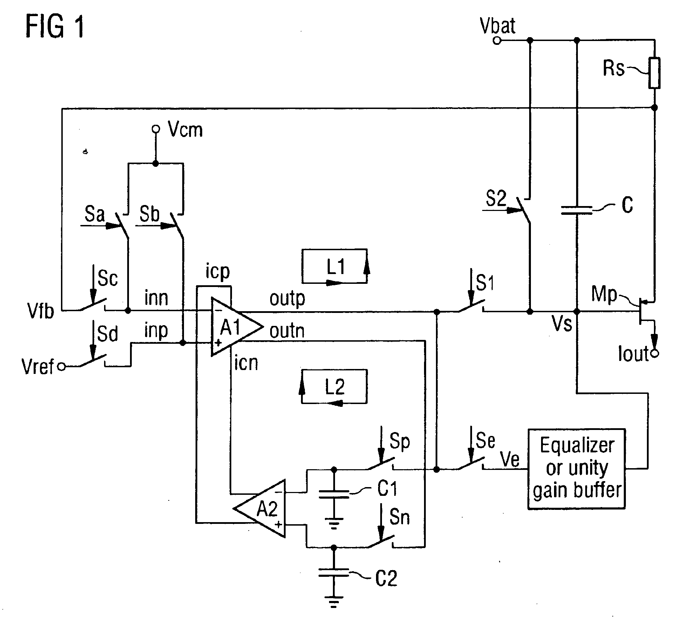

To this extent, FIG. 1 illustrates an embodiment of the proposed principle of a regulated current source. The regulated current source according to FIG. 1 comprises a main regulation loop L1 as indicated, and an offset cancellation loop L2.

The main regulation loop comprises an operational amplifier A1 which is implemented as a fully differential operational amplifier. The non-inverting output of the operational amplifier A1 providing output signal outp is coupled via a first switch S1 to the gate of the output transistor Mp providing the output current Iout. Between resistor Rs and output transistor Mp, a feedback node for feedback signal Vfb is coupled via switch SC to the inverting input of operational amplifier A1. The non-inverting input of amplifier A1 is connected via switch SD to a reference signal Vref. The two inputs of amplifier A1 are also connected via switches Sa and Sb to a common mode reference Vc. The switches Sa and Sb are operated in a specific mode as it will be explained in greater detail below. The common mode reference Vc could be the same as Vbat.

The offset cancellation loop comprises an operational amplifier A2 with an inverting and non-inverting input. The inverting input is connected via switch Sp to the inverting output of operational amplifier A1. The non-inverting input is coupled via switch Sn to the inverting output outn of operational amplifier A1. Further, capacitances C1 and C2 are connected between the inputs of amplifier A1 and the respective switches. They are used to store respective signals applied to operational amplifier during operation of the circuit. The output of operational amplifier providing output signals Icp and Icn are connected to respective supply terminals of operational amplifier A1.

To provide an offset cancellation and reduce any spikes during operation of the regulated current source, a unity gain buffer is substantially arranged in parallel to switch S1. Particularly, the unity gain buffer is coupled to a first node Vs between the gate of transistor Mp and switch S1 and with a second node via switch Se to the non-inverting output of operational amplifier A1.

Finally, node Vs is connected via capacitor C to supply terminal Vbat. Switch S2 for selectively activating or deactivating the regulated current source is arranged in parallel to capacitor C.

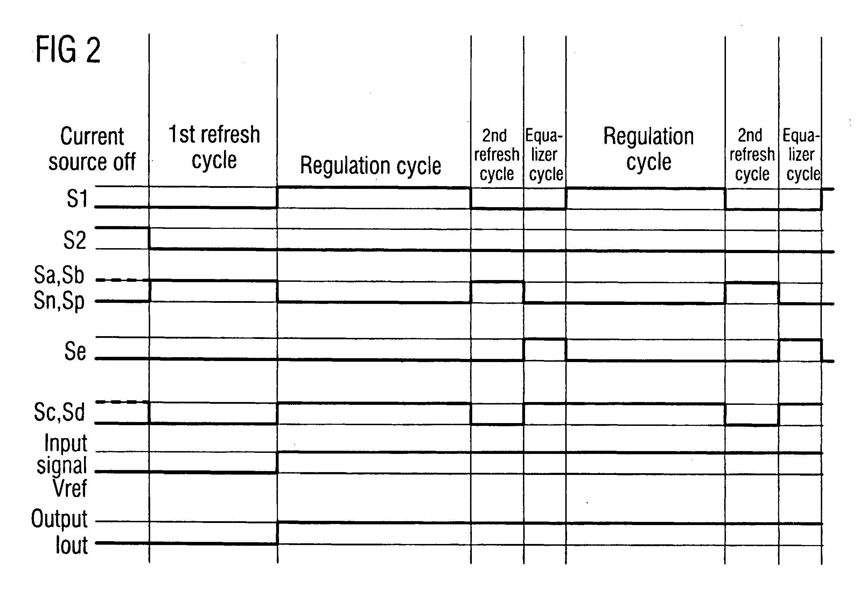

FIG. 2 illustrates a time-signal diagram of several signals applied to the embodiment of the regulated current source according to FIG. 1.

The regulated current source is operated in consecutive sequential cycles, namely regulation cycle, refresh cycle, and equalizer cycle. Starting with a first refresh cycle, switches S1, S2, Se, Sc and Sd are open, while switches Sa, Sb, Sn and Sp are closed. Common mode voltage signal Vcm is both applied to the non-inverting and to the inverting input of operational amplifier A2 of the main regulation loop. If there is no internal offset voltage in operational amplifier A1, the difference between the output signals outp and outn must be zero as well. If there is any offset, said offset will result in a difference applied to operational amplifier A2 of the offset cancellation loop. In response to any offset signal provided by operational amplifier A1, the offset cancellation loop provides output signals Icp and Icn to cancel the offset signal in amplifier A1.

After the first refresh cycle, the switches Sa, Sb, Sn and Sp are open and the current source starts the regulation cycle by closing switch S1, Sc and Sd. Reference signal Vref is now applied to operational amplifier A1. In response to a comparison between the feedback signal Vfb and the reference signal Vref, the operational amplifier provides an output signal outp applied to power transistor Mp to drive the transistor. The transistor provides the respective regulated output current Iout.

After the regulation cycle is finished, the second refresh cycle starts by opening switch S1, Sc and Sd, thereby separating the feedback signal Vfb as well as the reference signal Vref from the respective input terminals of operational amplifier A1. Similar to the first refresh cycle, any offset in operational amplifier A1 is cancelled by the offset cancellation loop L2.

The second refresh cycle and any refresh cycle afterwards is immediately followed by an equalizer cycle. For this purpose, switch S1 remains open, switches Sa, Sb, Sn and Sp are opened as well. Switch Se coupling the unity gain buffer to the output of operational amplifier A1 is now closed as well as switches Sc and Sd. The operational amplifier compares the feedback signal Vfb with the reference signal and provides an output signal outp to the still open switch S1. The unity gain buffer now arranged in parallel to switch S1 has the purpose of equalizing a signal at node VS with the signal outp provided by operational amplifier A1. After the equalization process at the end of the equalizer cycle, any potential at node VS is equal to the potential at the output of operational amplifier A1. Closing switch S1 with the beginning of the next regulation cycle will therefore not provoke any spike on the output current Iout.

Further, during the refresh and the equalizer cycle, the output current Iout is given by the output current during the last regulation cycle. This is achieved by the unity gain buffer arranged in parallel to switch S1 and capacitor C connected between node VS and supply terminal Vbat.

During the regulation cycle, switch S1 is closed and the feedback signal Vfb regulated to the reference signal Vref by the main regulation loop and the amplifier A1. The current output Iout is given by

$$Iout = (Vbat - Vref)/Rs$$

wherein Rs is the resistance value in the resistor connected between supply terminal Vbat and output transistor Mp.

In the refresh cycle following the regulation cycle, the operational amplifier A2 of the offset cancellation loop generates, if necessary, the supply signals Icp and Icn such that output signal outp is regulated to output signal outn of operational amplifier A1. During this phase, both capacitors C1 and C2 are charged to a value of outp = outn. The output current Iout stays to the value at the end of the previous regulation cycle.

In the following equalizer cycle, just before the next regulation cycle, the output node outp of operational amplifier A1 is equalized to the voltage at node VS. This equalization process assures that the voltage at VS and the control signal of operational amplifier A1 in the following regulation cycle are at the same potential before the start of the regulation cycle.

As such, the regulation cycle may be much longer than the following refresh and equalizer cycle. The equalizer cycle may be only a few per cent of the refresh cycle sufficient to equalize the signal at node VS with the output signal outp of operational amplifier A1. For example, the regulation cycle may be in the range of a few hundred μs up to a few milliseconds, while the refresh cycle is about a few μ-seconds. The equalizer cycle is only a few hundred nanoseconds long, and sufficiently long enough to obtain equalization of the potential on both sides of switch S1.

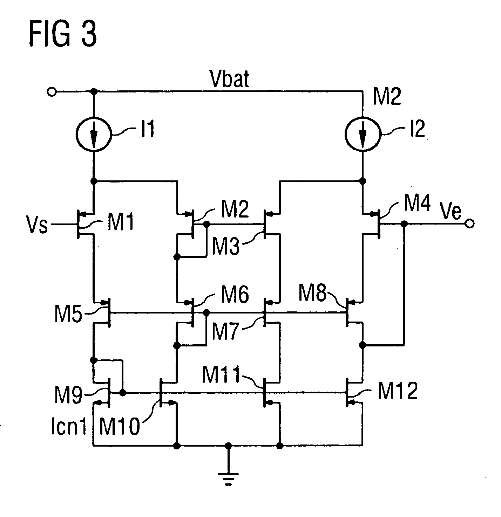

FIG. 3 illustrates a unity gain buffer to be used in the regulated current source according to the present invention. The unity gain buffer equalizes signal Vs applied to gate terminal of transistor M1 to output signal Ve. For this purpose, signal Vs is basically mirrored via transistors M1, M2, M3 and M4 to the respective output terminal. The current Icn1 given by current source I1 flowing through transistor M1, M5 and M9 is mirrored into transistor M10, M11 and M12. If the transistors M9 to M12 carry equal currents, the respective gate-to-source voltages of transistors M1, M2, M3 and M4 are equal as well. Hence, the output signal Ve provided at a node between transistor M8 and M12 and also applied to gate of transistor M4 is equal to input signal Vs. The current flowing through M2 and M6 is mirrored to transistors M3 and M7, respectively.

The embodiment of FIG. 3 provides an output signal Ve equal to node Vs without loading the node Vs itself. This feature is important for a continuous output current Iout.

As a result, the equalizer according to FIG. 3 smoothly transfers the original value of signal at node VS to the operational output terminal of amplifier A1 without loading the node VS itself. At the end of the equalizer cycle, both signals are equal and after switch S1 is closed, no spike or signal transient in the control signal applied to gate terminal of transistor Mp takes place.

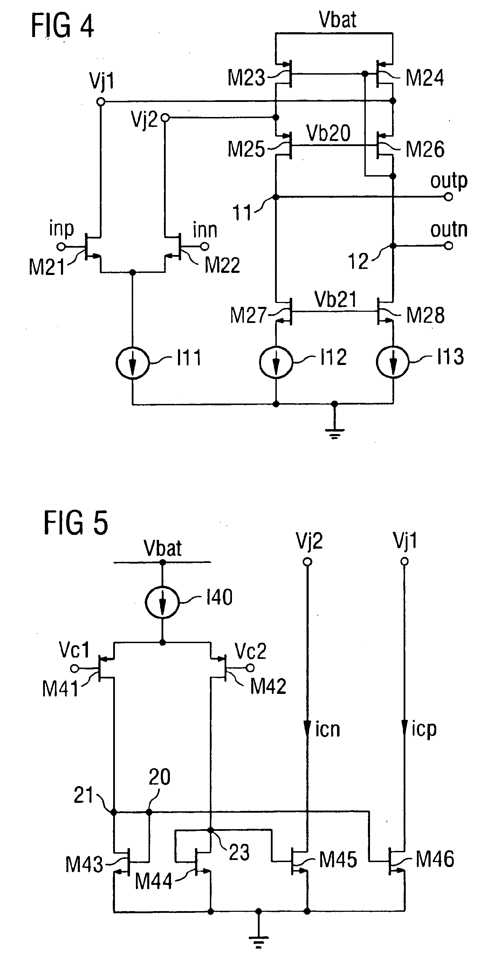

An embodiment of an operational amplifier to be used for the main regulation loop is illustrated in FIG. 4. The voltage to voltage amplifier comprises an input portion including a differential amplifier with transistors M21 and M22 as well as an output portion with nodes 11 and 12 for providing output voltage signals outp and outn. A supply terminal provides the supply voltage to transistors M23 and M24 in the output path, which are connected to transistors M25 and M26, respectively. A node between transistor M23 and M25 is coupled to transistor M22 of the differential amplifier. A node between transistors M24 and M26 is connected to transistor M21 of the differential amplifier. The gates of transistors M23 and M24 are coupled to output node 12.

In operation of the amplifier according to FIG. 4, the feedback signal and the reference signal are applied to the respective input terminals inn or inp, respectively. The amplifier provides a current to the output path and to the respective nodes.

To cancel an existing offset of the operational amplifier in FIG. 4, additional current is substracted or added at nodes Vj1 and Vj2, respectively. These nodes are arranged between transistors M23, M25 and M24, M26. The added or substracted current cancels any offset in the output signals outp, outn of the differential amplifier.

FIG. 5 illustrates an embodiment of a voltage to current amplifier used in the offset cancellation loop. The amplifier comprises a differential amplifier including transistors M41 and M42. At the gate of transistor M41, the voltage signal VC1 generated by capacitor C1 in the embodiment of FIG. 1 is applied, too. Accordingly, the gate of transistor M42 receives signal VC2 originated from capacitor C2. Transistor M43 is connected in series to transistor M41 and coupled with its gate to node 21. Transistor M44 is coupled with its gate to node 23. Nodes 21 and 23 are the output nodes of the differential amplifier and connected to the gates of current output transistors M45 and M46. Depending on the signals VC2, VC1 applied to the gates of the differential amplifier transistors, the output transistors M45 and M46 provide respective output currents Icn and Icp to nodes Vj2 and Vj1, respectively.

Reference list

| | |
|---|---|
| L1 | regulation loop |
| L2, L3 | offset cancellation loop |
| A1 | operational amplifier |
| A2, A3, A4 | operational amplifier |
| C1, C2 | capacitors |

| S1, S2 | switches |
|---|---|
| SA, SB | switches |
| SC, SD | switches |
| SP, SN, SE | switches |
| C | capacitor |
| VS | node |
| Mp | output transistor |
| Iout | output current |
| Vbat | supply signal, supply terminal |
| outp | control signal, output of operational am- |
| plifier outn | output of operational amplifier |
| Icn, Icp | supply signals |
| M21, M22 | amplifier transistors |
| M23, M24, M25, M26 | transistors |
| 11, 12 | nodes |
| M1, M2, M3, M4 | transistors |
| M5, M6, M7, M8 | transistors |
| M9, M10, M11, M12 | transistors |
| 11, 12, 13 | current sources |
| VJ1, VJ2 | nodes |

**Claims**

1. A regulated current source, comprising:

   - controllable output means (Mp), coupled to a supply terminal and to an output terminal to provide an output current (Iout);
   - a first regulation loop comprising first comparing means (A1) to provide a control signal to the controllable output means (Mp) in response to a feedback signal (Vfb) and a reference signal (Vref);

   **characterized by** further comprising:

   - a first switch (S1) between the controllable output means (Mp) and an output of the first comparing means (A1);
   - an offset cancellation loop having second comparing means (A2) coupled with its input to the output of the first comparing means (A1) to provide an offset cancellation signal to the first comparing means (A1)
   - a unity gain buffer that is coupled to a node (Vs) between the first switch (S1) and the controllable output means (Mp) and that is selectively switchable arranged in parallel to the first switch (S1).

2. The current source of claim 1, wherein

- the current source is adapted to close the first switch (S1) during a regulation cycle of the first regulation loop;
- the offset cancellation loop is adapted to provide the offset cancellation signal during a refresh cycle of the first regulation loop;
- the current source is adapted to operate the unity gain buffer between the refresh cycle and the regulation cycle.

3. The current source according to any of claims 1 to 2, wherein the first comparing means comprise a differential operational amplifier (A1), wherein one output is coupled to the first switch (S1).

4. The current source according to any of claims 1 to 3, wherein the second comparing means comprise a differential amplifier (A2), coupled with its inputs via respective switches (Sp, Sn) to the output of the first comparing means (A1) and with its output to a supply of the first comparing means.

5. The current source according to any of claims 1 to 4, wherein the second comparing means comprise at least one capacitor (C1, C2) coupled between one of the inputs and the respective switch (Sp, Sn).

6. The current source according to any of claims 1 to 5, further comprising a capacitor (C) coupled to the supply terminal and the node (Vs).

7. The current source according to any of claims 1 to 6, further comprising switching means (Sa, Sb) coupled to a common reference and to the input of the first regulation loop, the switching means (Sa, Sb) to be operated, in particular to be closed, during the refresh cycle.

8. The current source according to any of claims 1 to 7, wherein the unity gain buffer is adapted to mirror a signal at the node (Vs) to the output of the first regulation loop between the refresh cycle and the regulation cycle.

9. Method for operating a regulated current source, the regulated current source having an output device (Mp) and a regulation loop (L1) comprising a comparator (A1), the method comprising:

- regulating an output current by comparing a feedback signal (Vfb) with a reference signal to provide a current control signal in response thereto;
- evaluating an offset in the regulation loop;
- applying an offset cancellation signal to the regulation loop in response to evaluating the offset;
- equalizing a potential on a control input of the output device (Mp) to an output of the comparator before regulating an output current.

10. The method according to claim 9, wherein the step of evaluating an offset is done in a first time period, the step of equalizing a potential is done in a subsequent second time period and the steps of regulating an output current and applying an offset cancellation signal are done in a subsequent third time period.

11. The method of claim 10, wherein the first, second and third time period are cyclically repeated, wherein the third time period is longer than the first time period and the first time period is longer than the second time period.

**Patentansprüche**

1. Geregelte Stromquelle, Folgendes aufweisend:

- steuerbare Ausgangseinrichtungen (Mp), die auf einen Versorgungsanschluss und einen Ausgangsanschluss aufgeschaltet sind, um einen Ausgangsstrom (Iout) bereitzustellen;
- eine erste Regelschleife mit ersten Vergleichseinrichtungen (A1), um den steuerbaren Ausgangseinrichtungen (Mp) im Ansprechen auf ein Rückkopplungssignal (Vfb) und ein Bezugssignal (Vref) ein Steuersignal bereitzustellen;

**dadurch gekennzeichnet, dass** sie darüber hinaus aufweist:

- einen ersten Schalter (S1) zwischen den steuerbaren Ausgangseinrichtungen (Mp) und einem Ausgang der ersten Vergleichseinrichtungen (A1);

- eine Versatzannullierungsschleife mit zweiten Vergleichseinrichtungen (A2), die mit ihrem Eingang auf den Ausgang der ersten Vergleichseinrichtungen (A1) aufgeschaltet ist, um den ersten Vergleichseinrichtungen (A1) ein Versatzannullierungssignal bereitzustellen;

- einen Zwischenspeicher für eine Verstärkung mit dem Verstärkungsfaktor Eins, der auf einen Knoten (Vs) zwischen dem ersten Schalter (S1) und den steuerbaren Ausgangseinrichtungen (Mp) aufgeschaltet und selektiv schaltbar parallel zum ersten Schalter (S1) angeordnet ist.

2. Stromquelle nach Anspruch 1, wobei

- die Stromquelle dazu angepasst ist, den ersten Schalter (S1) während eines Regelzyklus der ersten Regelschleife zu schließen;
- die Versatzannullierungsschleife dazu angepasst ist, das Versatzannullierungssignal bereitzustellen, und zwar während eines Auffrischungszyklus der ersten Regelschleife;
- die Stromquelle dazu angepasst ist, den Zwischenspeicher für eine Verstärkung mit dem Verstärkungsfaktor Eins zwischen dem Auffrischungszyklus und dem Regelzyklus zu aktivieren.

3. Stromquelle nach einem der Ansprüche 1 bis 2, wobei die ersten Vergleichseinrichtungen einen Differentialoperationsverstärker (A1) aufweisen, wobei ein Ausgang auf den ersten Schalter (S1) aufgeschaltet ist.

4. Stromquelle nach einem der Ansprüche 1 bis 3, wobei die zweiten Vergleichseinrichtungen einen Differentialoperationsverstärker (A2) aufweisen, der mit seinen Eingängen über jeweilige Schalter (Sp, Sn) auf den Ausgang der ersten Vergleichseinrichtungen (A1) und mit seinem Ausgang auf eine Versorgung der ersten Vergleichseinrichtungen aufgeschaltet ist.

5. Stromquelle nach einem der Ansprüche 1 bis 4, wobei die zweiten Vergleichseinrichtungen mindestens einen Kondensator (C1, C2) aufweisen, der zwischen den Eingängen und dem jeweiligen Schalter (Sp, Sn) zwischengeschaltet ist.

6. Stromquelle nach einem der Ansprüche 1 bis 5, darüber hinaus einen Kondensator (C) aufweisend, der auf den Versorgungsanschluss und den Knoten (Vs) aufgeschaltet ist.

7. Stromquelle nach einem der Ansprüche 1 bis 6, darüber hinaus Schalteinrichtungen (Sa, Sb) aufweisend, die auf einen gemeinsamen Bezug und auf den Eingang der ersten Regelschleife aufgeschaltet sind, wobei die Schalteinrichtungen (Sa, Sb) während des Auffrischungszyklus zu aktivieren, insbesondere zu schließen sind.

8. Stromquelle nach einem der Ansprüche 1 bis 7, wobei der Zwischenspeicher für eine Verstärkung mit dem Verstärkungsfaktor Eins dazu angepasst ist, zwischen dem Auffrischungszyklus und dem Regelzyklus ein Signal am Knoten (Vs) zum Ausgang der ersten Regelschleife zu spiegeln.

9. Verfahren zum Betreiben einer geregelten Stromquelle, wobei die geregelte Stromquelle über eine Ausgangsvorrichtung (Mp) und eine Regelschleife (L1) mit einem Komparator (A1) verfügt, wobei das Verfahren umfasst:

- Regeln eines Ausgangsstroms durch Vergleichen eines Rückkopplungssignals (Vfb) mit einem Bezugssignal, um im Ansprechen darauf ein Stromsteuersignal bereitzustellen;
- Auswerten eines Versatzes in der Regelschleife;
- Anlegen eines Versatzannullierungssignals an die Regelschleife im Ansprechen auf die Auswertung des Versatzes;
- Abgleichen eines Potentials an einem Steuereingang der Ausgangsvorrichtung (Mp) mit einem Ausgang des Komparators, bevor ein Ausgangsstrom geregelt wird.

10. Verfahren nach Anspruch 9, wobei der Schritt des Auswertens eines Versatzes in einem ersten Zeitraum erfolgt, der Schritt des Abgleichens eines Potentials in einem anschließenden, zweiten Zeitraum erfolgt, und die Schritte des Regelns eines Ausgangsstroms und des Anlegens eines Versatzannullierungssignals in einem anschließenden, dritten Zeitraum erfolgen.

11. Verfahren nach Anspruch 10, wobei der erste, zweite und dritte Zeitraum sich zyklisch wiederholen, wobei der dritte Zeitraum länger als der erste Zeitraum ist, und der erste Zeitraum länger als der zweite Zeitraum ist.

**Revendications**

1.  Source de courant régulée, comprenant:

    - des moyens de sortie pouvant être commandés (Mp), reliés à une borne d'alimentation et à une borne de sortie pour fournir un courant de sortie (Iout);
    - une première boucle de régulation comprenant des premiers moyens de comparaison (A1) pour fournir un signal de commande aux moyens de sortie pouvant être commandés (Mp) en réponse à un signal de rétroaction (Vfb) et à un signal de référence (Vref);

    **caractérisée en ce qu'**elle comprend en outre:

    - un premier commutateur (S1) entre les moyens de sortie pouvant être commandés (Mp) et une sortie des premiers moyens de comparaison (A1);
    - une boucle d'annulation de décalage présentant des deuxièmes moyens de comparaison (A2) reliés par leur entrée à la sortie des premiers moyens de comparaison (A1) pour fournir un signal d'annulation de décalage aux premiers moyens de comparaison (A1);
    - un tampon de gain unitaire qui est relié à un noeud (Vs) entre le premier commutateur (S1) et les moyens de sortie pouvant être commandés (Mp) et qui est disposé en parallèle au premier commutateur (S1) de manière à pouvoir être commuté sélectivement.

2.  La source de courant de la revendication 1, dans laquelle

    - la source de courant est apte à fermer le premier commutateur (S1) pendant un cycle de régulation de la première boucle de régulation;
    - la boucle d'annulation de décalage est apte à fournir le signal d'annulation de décalage pendant un cycle de rafraîchissement de la première boucle de régulation;
    - la source de courant est apte à faire fonctionner le tampon de gain unitaire entre le cycle de rafraîchissement et le cycle de régulation.

3.  La source de courant selon l'une quelconque des revendications 1 à 2, dans laquelle les premiers moyens de comparaison comprennent un amplificateur opérationnel différentiel (A1), dans lequel une sortie est reliée au premier commutateur (S1).

4.  La source de courant selon l'une quelconque des revendications 1 à 3, dans laquelle les deuxièmes moyens de comparaison comprennent un amplificateur différentiel (A2), relié par ses entrées via des commutateurs respectifs (Sp, Sn) à la sortie des premiers moyens de comparaison (A1) et par sa sortie à une alimentation des premiers moyens de comparaison.

5.  La source de courant selon l'une quelconque des revendications 1 à 4, dans laquelle les deuxièmes moyens de comparaison comprennent au moins un condensateur (C1, C2) relié entre une des entrées et le commutateur respectif (Sp, Sn).

6.  La source de courant selon l'une quelconque des revendications 1 à 5, comprenant en outre un condensateur (C) relié à la borne d'alimentation et au noeud (Vs).

7.  La source de courant selon l'une quelconque des revendications 1 à 6, comprenant en outre des moyens de commutation (Sa, Sb) reliés à une référence commune et à l'entrée de la première boucle de régulation, les moyens de commutation (Sa, Sb) devant être actionnés, en particulier devant être fermés, pendant le cycle de rafraîchissement.

8.  La source de courant selon l'une quelconque des revendications 1 à 7, dans laquelle le tampon de gain unitaire est apte à refléter en miroir un signal au niveau du noeud (Vs) sur la sortie de la première boucle de régulation entre le cycle de rafraîchissement et le cycle de régulation.

9.  Procédé de fonctionnement d'une source de courant régulée, la source de courant régulée présentant un appareil de sortie (Mp) et une boucle de régulation (L1) comprenant un comparateur (A1), le procédé comprenant:

- la régulation d'un courant de sortie par comparaison d'un signal de rétroaction (Vfb) avec un signal de référence pour fournir un signal de commande de courant en réponse à ceux-ci;
- l'évaluation d'un décalage dans la boucle de régulation;
- l'application d'un signal d'annulation de décalage à la boucle de régulation en réponse à l'évaluation du décalage;
- l'égalisation d'un potentiel sur une entrée de commande de l'appareil de sortie (Mp) à une sortie du comparateur avant la régulation d'un courant de sortie.

**10.** Le procédé selon la revendication 9, dans lequel l'étape d'évaluation d'un décalage est effectuée dans une première période de temps, l'étape d'égalisation d'un potentiel est effectuée dans une deuxième période de temps subséquente et les étapes de régulation d'un courant de sortie et d'application d'un signal d'annulation de décalage sont effectuées dans une troisième période de temps subséquente.

**11.** Le procédé de la revendication 10, dans lequel la première, la deuxième et la troisième période de temps se répètent de manière cyclique, dans lequel la troisième période de temps est plus longue que la première période de temps et la première période de temps est plus longue que la deuxième période de temps.

# FIG 1

# FIG 2

EP 2 533 128 B1

# FIG 3

## FIG 4

## FIG 5

# FIG 6

**EP 2 533 128 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2197244 A1
- US 20070290746 A1